# EUROPEAN PATENT SPECIFICATION

(11) **EP 0 337 609 B1**
(45) Date of publication and mention of the grant of the patent: **27.07.1994**
(21) Application number: 89302468.7
(22) Date of filing: 14.03.1989
(51) Int. Cl.: H03J 7/18

(54) **Radio data system receivers**
RDS-Funkempfänger
Récepteurs radio RDS

(30) Priority: 16.03.1988 GB 8806200
(43) Date of publication of application: 18.10.1989
(73) Proprietor: BRITISH BROADCASTING CORPORATION, London W1A 1AA (GB)
(72) Inventor: Ely, Stephen Robert, Tadworth Surrey KT20 6NP (GB); Saunders, Mark Stephen, Tadworth Surrey KT20 6NP (GB); Marks, Beverley, Tadworth Surrey KT20 6NP (GB); Taylor, E. William, Tadworth Surrey KT20 6NP (GB); Parnall, Simon John, Tadworth Surrey KT20 6NP (GB); Taylor, Graham Henry, Tadworth Surrey KT20 6NP (GB); Riley, John Lawrence, Tadworth Surrey KT20 6NP (GB); Thoday, Robert David Cyril, Tadworth Surrey KT20 6NP (GB)
(74) Representative: Abnett, Richard Charles

(56) References cited:
- EP-A- 0 155 728
- EP-A- 0 233 967
- GB-A- 2 015 837
- FUNKSCHAU, no. 23, November 1981, pages 69-73, Munich, DE; H. KELLER: "FM-synthesizer-tuner"
- PATENT ABSTRACTS OF JAPAN, vol. 1, no. 56 (E-76)[3604], 30th May 1977 & JP-A-51 150 211
- PATENT ABSTRACTS OF JAPAN, vol. 7, no. 251 (E-209)[1396], 8th November 1983 & JP-A-58 137 334

## Description

The Radio Data System RDS was developed under the auspices of the European Broadcasting Union (EBU) who publish its specification, "Specification of the radio data system RDS for VHF/FM sound broadcasting" EBU Document 3244-E, 1984. The main objective of this system is to facilitate the realisation of automatic tuning features in new receivers by using the Programme Identification (PI) code, Alternative Frequency (AF) codes, and, where appropriate, Other Network (ON) features of RDS. The various codes are carried by a digital data channel accompanying the broadcast programme.

The object of the present invention is to provide a means of improving a radio receiver which uses the RDS system by making it easier to select programme services when the receiver is first turned on from new. The invention is applicable to all categories of radio receiver, including those used in cars, portable receivers, and hi-fi tuners.

In normal use, the listener who uses an RDS receiver will have no need to be concerned with frequencies or wavelengths to select a desired programme service but will be able to select his choice using preset push-buttons. Unlike an ordinary receiver, in which the push-buttons select a particular frequency or group of frequencies manually entered by the listener or his dealer, push-buttons on an RDS receiver will select a particular programme service (which is uniquely identified by the 16-bit PI code of the broadcast RDS signal). The receiver will then automatically search to find the best frequency for reception of the desired programme in the particular area that the receiver, is at present located. If the receiver is moved it will use the RDS AF and ON features to keep track of the best frequencies for reception of the preselected programmes.

A problem arises, however, in that when the RDS receiver is first turned on after purchase the push-buttons will not have any PI code associated with them and the listener must use conventional tuning techniques to find the stations of his choice. Various methods of auto-store tuning are known which initiate a scan of the frequency bands and store, typically, the six strongest stations against the push-buttons. But this is a lengthy process (which is a serious disadvantage when the receiver is being demonstrated) and since the stations are stored in frequency order (from lowest to highest transmitted frequency) does not lead to a logical correspondence between the station name and the button which the receiver associates with that frequency. For example, in the UK listeners may be expected to select Radio 1 with button one, Radio 2 with button 2 etc. A conventional auto-store will however result in Radio 2 being selected by button 2 and Radio 1 by button 6 (because in the London area Radio 2 is on the lowest receivable frequency in Band II and Radio 1 on the highest).

The proposed solution to this problem is that the manufacturer should include in the receiver software a set of default PI codes associated with the push-buttons so that on turning the receiver on from new the listener will immediately find a usable programme signal on each push-button and the correspondence between the button pushed and the programme service selected will be easy to understand, (i.e. for the UK, Radio 1 should appear on button One, and so on).

The listener may subsequently overwrite the manufacturer's preselection with his own choice of services but the original preselection should be capable of recall at any time using a reset button or functionally equivalent series of button-pushes.

A further refinement to the invention comprises the receiver storing different sets of default PI code selection appropriate for different countries. The receiver loads the appropriate PI codes (and perhaps other data) according to the broadcast RDS country code (which is included as the first 4 bits of the PI code) on the first (or listener selected) station to which the receiver is tuned when switched on from new. This feature should also be capable of being re-initialised to allow a new selection to be automatically loaded when the receiver is moved to a new country.

Alternative methods for loading the PI codes into the stores associated with each push-button would comprise loading them from some external storage medium. This could include, for example, a special audio cassette replayed via a cassette player built into the receiver, Compact Disc or RDAT player or bar-code information read via a light-pen or scanner.

Funkschau, 1981, No. 23, pages 69 to 73 discloses an FM synthesizer tuner with push-buttons and also with a stored table which makes it possible to display the station and programme number being received on the frequency selected manually or by push-button control, in accordance with entry of the station area in which the receiver is situated. The stored table performs no function in relation to programming push-buttons.

EP-A 0 155 728 relates to re-programming a frequency synthesised multichannel radio transceiver by means of an external data transfer unit. The transceiver does not comprise push-buttons, nor any store corresponding to the "second store" of the present invention.

It should be noted that the invention does not constrain the broadcaster in allocating PI codes to his broadcast services (other than in using the country codes prescribed by the RDS Specification). It does, however, require that PI codes chosen by the broadcasters are known to the receiver manufacturers.

The invention will be described in more detail, by way of example, with reference to the accompanying drawings, in which:
Fig. 1 is a block diagram of a simple embodiment, and
Fig. 2 is a block diagram of a more complex embodiment.

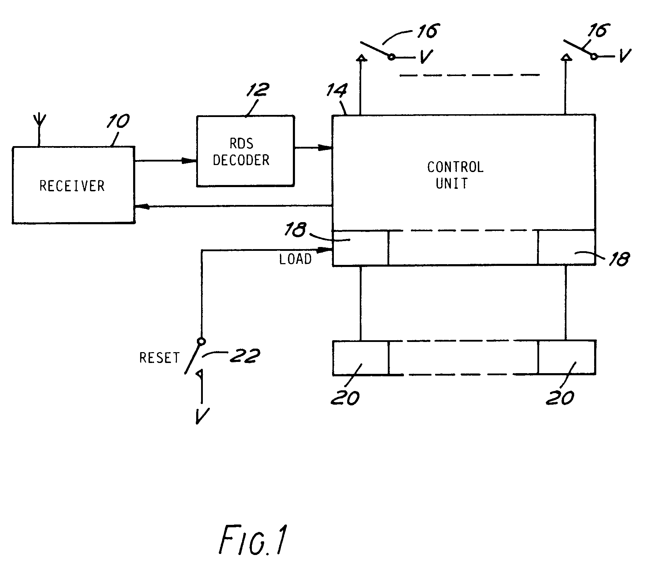

Fig. 1 shows very schematically the main components of a known RDS radio receiver, comprising the receiver proper 10, an RDS decoder 12 for decoding the RDS information received by the receiver, a control unit 14 which controls the receiver 10 in dependence upon the RDS information and in dependence upon the operation of push buttons 16, say eight push buttons. One part of the control unit 14 consists of eight registers 18 which store the user-selected PI codes corresponding to the push buttons 16 respectively. These registers will in practice be implemented in battery-backed RAM so that the PI codes are always available whenever the receiver is switched on. This apparatus forms part of the state of the art and will not be described in any more detail.

The system further comprises a set of initial setting registers 20 in one-to-one correspondence with the user registers 18 and connected thereto for loading the contents of the registers 20 into the corresponding registers 18. The registers 20 are implemented in a ROM. Loading is effected by a signal provided by a reset switch 22. Whenever the switch 22 is pushed the contents of the registers 20 are loaded into the registers 18, overwriting any previous contents. The reset switch is used when the receiver is first switched on to put a standard set of PI codes into the registers 18 and may be used thereafter as and when required, e.g. after loss of battery back-up and hence loss of the contents of the registers 18. The user does not have to stick with the PI codes thus loaded. He can subsequently set any desired code into a register 18 in the manner provided for in the RDS receiver in any event.

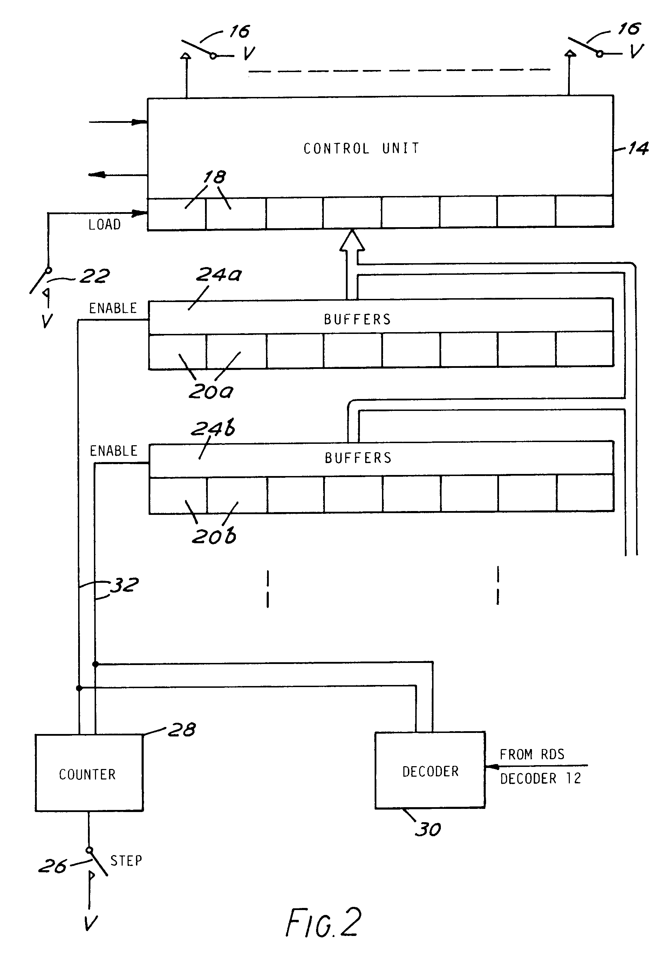

Fig. 2 shows part of a system with added facilities. The set of registers 20 is replaced by a plurality of sets 20a, 20b... storing different standard sets of PI codes appropriate to different countries. The sets of registers 20a, 20b... are connected to the registers 18 through respective buffers 24a, 24b... When the reset button 22 is pressed, the registers 18 are loaded with the contents of one set of registers 20a, 20b..., selected by enabling the corresponding buffers.

Two alternative mechanisms are shown for effecting the selection; in practice only one is likely to be implemented in any given receiver. On mechanism comprises another push button switch 26 which pulses a cyclic counter arrangement 28 providing enabling outputs to the buffers 24a, 24b... Each press of the switch 26 steps the enabling signal on to the next set of buffers.

The other mechanism comprises a decoder 30 which receives the four most significant received PI code bits from the decoder 12 and decodes these bits to the lines 32 providing the enabling signals to the sets of buffers 24a, 24b...

There are many alternative receiver arrangements possible within the scope of the invention.

## Claims

1. An RDS push-button radio receiver comprising a first PI code store (18) for storing a first set of user-selectable PI codes associated with the push-buttons (16) respectively, characterized by a second PI code store (20) permanently storing a second set of default PI codes available when no user-selected PI codes have been entered, and means (22) for loading the second set of PI codes from the second PI code store (20) into the first PI code store (18).

2. A receiver according to claim 1, characterized in that the second store (20a, 20b,...) stores a plurality of second sets of default PI codes pertaining to different countries, and by means (30, 24a, 24b,...) responsive to the country code in a received PI code to select the corresponding second set of default PI codes for loading into the first PI code store (18).

3. An RDS push-button radio receiver comprising a PI code store (18) for storing a first set of user-selectable PI codes associated with the push-buttons (16) respectively, characterized by input means for loading a default set of PI codes from an external storage medium into the PI code store (18).

4. An RDS push-button radio receiver according to claim 3, characterized in that the input means comprise a playback device incorporated in the receiver for playing back the storage medium.

5. An RDS push-button radio receiver according to claim 3, characterized in that the input means comprise means responsive to bar code data.

## Patentansprüche

1. RDS-Drucktasten-Funkempfänger, aufweisend einen ersten PI-Codespeicher (18) zum Speichern eines ersten Satzes benutzerselektierbarer PI-Codes, die Jeweils den Drucktasten (16) zugeordnet sind,
**gekennzeichnet durch**
einen Zweiten PI-Codespeicher (20), der permanent einen zweiten Satz von Standard-PI-Codes speichert, die zur Verfügung stehen, wenn keine benutzerselektierten PI-Codes eingegeben worden sind, und durch eine Einrichtung (22) zum Laden des zweiten Satzes von PI-Codes aus dem zweiten PI-Codespeicher (20) in den ersten PI-Codespeicher (18).

2. Empfänger nach Anspruch 1,
**dadurch gekennzeichnet,**
daß der zweite Speicher (20a, 20b, ...) mehrere zweiter Sätze von Standard-PI-Codes speichert, die zu unterschiedlichen Ländern gehören, und gekennzeichnet durch eine Einrichtung (30, 24a, 24b, ...), die auf den Ländercode in einem empfangenen PI-Code reagiert, um den entsprechenden zweiten Satz von Standard-PI-Codes zum Laden in den ersten PI-Code-Speicher (18) zu selektieren.

3. RDS-Drucktastenfunkempfänger, aufweisend einen PI-Codespeicher (18) zum Speichern eines ersten Satzes von benutzerselektierbaren PI-Codes, die jeweils den Drucktasten (16) zugeordnet sind,
**gekennzeichnet durch**
eine Eingabeeinrichtung zum Laden eines Standardsatzes von PI-Codes aus einem externen Speichermedium in den PI-Codespeicher (18).

4. RDS-Drucktastenfunkempfänger nach Anspruch 3,
**dadurch gekennzeichnet,**
daß die Eingabeeinrichtung eine Wiedergabevorrichtung umfaßt, die im Empfänger zum Abspielen des Speichermediums eingebaut ist.

5. RDS-Drucktastenfunkempfänger nach Anspruch 3,
**dadurch gekennzeichnet,**
daß die Eingabeeinrichtung eine Einrichtung umfaßt, die auf Barcodedaten anspricht.

## Revendications

1. Récepteur radio à bouton poussoir RDS comprenant une première mémoire de codes PI (18) pour stocker un premier jeu de codes PI pouvant être sélectionné par l'utilisateur associés respectivement aux boutons poussoirs (16), caractérisé par une seconde mémoire de codes PI (20) qui stocke en permanence un second jeu de codes PI par défaut disponibles lorsqu'aucun code PI sélectionné par l'utilisateur n'a été entré et un moyen (22) pour charger le second jeu de codes PI à partir de la seconde mémoire de codes PI (20) dans la première mémoire de codes PI (18).

2. Récepteur selon la revendication 1, caractérisé en ce que la seconde mémoire (20a, 20b, ...) stocke une pluralité de seconds jeux de codes PI par défaut appartenant à différents pays et caractérisé par un moyen (30, 24a, 24b, ...) sensible au code de pays contenu dans un code PI reçu pour sélectionner le second jeu correspondant de codes PI par défaut en vue d'un chargement dans la première mémoire de codes PI (18).

3. Récepteur radio à bouton poussoir RDS comprenant une mémoire de codes PI (18) pour stocker un premier jeu de codes PI pouvant être sélectionnés par l'utilisateur associés respectivement aux boutons poussoirs (16), caractérisé par un moyen d'entrée pour charger un jeu par défaut de codes PI depuis un support de stockage externe dans la mémoire de codes PI (18).

4. Récepteur radio à bouton poussoir RDS selon la revendication 3, caractérisé en ce que le moyen d'entrée comprend un dispositif de lecture incorporé dans le récepteur pour lire le support de stockage.

5. Récepteur radio à bouton poussoir RDS selon la revendication 3, caractérisé en ce que le moyen d'entrée comprend un moyen sensible à des données de code à barres.
